# EUROPEAN PATENT APPLICATION

(11) **EP 2 743 982 A2**
(43) Date of publication of application: **18.06.2014**
(21) Application number: 13193891.2
(22) Date of filing: 21.11.2013
(51) Int. Cl.: H01L 27/12, H01L 29/66, H01L 29/786, H01L 29/49

(54) **Display device, array substrate and manufacturing method thereof**

(30) Priority: 14.12.2012 CN 201210546214
(71) Applicant: Boe Technology Group Co. Ltd., Beijing 100015 (CN)
(72) Inventor: Liu, Xiang, 100176 Beijing (CN); Wang, Gang, 100176 Beijing (CN); Xue, Jianshe, 100176 Beijing (CN)
(74) Representative: Brötz, Helmut

(57) **Abstract**

A display device, an array substrate and a manufacturing method thereof are provided. The array substrate comprises a substrate, a gate electrode on the substrate, a gate insulating layer, an active layer, an etch stop layer, a source/drain electrode layer, a passivation layer and a pixel electrode layer; wherein the active layer is a metal oxide semiconductor, a metal oxide insulating layer is provided between the gate insulating layer and the active layer, the gate insulating layer is located between the gate electrode and the metal oxide insulating layer, and the metal oxide insulating layer is located between the gate insulating layer and the active layer.

## Description

### FIELD OF THE INVENTION

Embodiments of the present invention relate to a display device, an array substrate and a manufacturing method thereof.

### BACKGROUND

Along with the development of science and technology, the flat panel display has replaced the bulky CRT display and gone deeply into people's daily life. Currently, commonly used flat panel displays comprise an LCD (Liquid Crystal Display) and an OLED (Organic Light-Emitting Diode) display. Especially, the LCD flat panel display gets quick development due to advantages of small volume, small weight and thickness, low power consumption, and no radiation and etc. The LCD flat panel display takes a leading status in the current flat panel display market and is widely used in large, medium and small-sized products, almost covering most of the electronic products in the current information society, such as the fields of liquid crystal TV, computer, mobile phone, vehicle-mounted display, projection display, camera, digital camera, electronic watch, calculator, electronic instrument, meters, common display and phantom display.

In the process of imaging, each liquid crystal pixel point in the LCD display is driven by a thin film transistor (TFT) integrated in a TFT array substrate, and achieves image display cooperating with a peripheral drive circuit; in an active matrix OLED (Active Matrix Organic Light Emission Display, AMOLED for short) display, a TFT in a TFT substrate drives a corresponding OLED pixel in an OLED panel, and then achieves image display cooperating with a peripheral drive circuit. In the above display, the TFT is a switch controlling light emission and a key component for achieving a large size of the liquid crystal display and the OLED display, and is in direct connection with the development direction of a high performance flat panel display.

In the prior manufacturing technology of the flat panel display, industrialized TFT mainly comprises an a-Si TFT, polycrystalline silicon, monocrystalline silicon and etc. The a-Si TFT is used the most in manufacturing the array substrate in the flat panel display. Currently, along with the development of technology, a metal oxide TFT appears. The metal oxide TFT has an advantage of high carrier mobility so that the TFT can be made much small, and then the flat panel display has a higher resolution, a better display effect is achieved. Meanwhile, the metal oxide TFT also has the advantages of less non-uniform characteristics, lowered material and process costs, low temperature, being able to use a coating process, high transparent rate, large band gap and etc., thus it gets wide attention in the field.

However, in the current metal oxide TFT, when a low-resistance Cu wire is used at a high temperature, Cu ions pass through a gate insulating layer and are diffused into a semiconductor layer, which deteriorates the performance of the TFT. In addition, when a nitride is used as the gate insulating layer, a portion of H ions in the nitride will be diffused to the semiconductor layer, then the performance of an oxide semiconductor layer is sharply deteriorated and then the performance of TFT products is seriously affected.

In addition, currently the metal oxide TFT is usually produced with six-patterning process, this is mainly because the metal oxide semiconductor layer will be eroded during etching source/drain metal electrodes, an etch stop layer is usually added on the metal oxide semiconductor layer to prevent the metal oxide semiconductor layer from being eroded by an etching liquid of a source/drain metal during etching the source/drain metal electrode. Generally speaking, the smaller the number of the mask plates used in manufacturing the metal oxide TFT is, the higher the production efficiency is and the lower the cost is.

### SUMMARY

One aspect of the embodiments of the invention provides an array substrate, comprising: a substrate; a gate electrode, a gate insulating layer, an active layer, an etch stop layer, a source/drain electrode layer, a passivation layer and a pixel electrode layer on the substrate; wherein, the active layer is a metal oxide semiconductor, a metal oxide insulating layer is provided between the gate insulating layer and the active layer, the gate insulating layer is located between the gate electrode and the metal oxide insulating layer, and the metal oxide insulating layer is located between the gate insulating layer and the active layer.

In one example, the metal oxide insulating layer has an area larger than or equal to that of the active layer.

In one example, the metal oxide insulating layer contacts the active layer.

In one example, the gate electrode is copper or copper alloy.

In one example, the metal oxide insulating layer is an aluminum oxide (Al₂O₃) thin film, a tantalum pentoxide (Ta₂O₅) thin film or a yttrium oxide (Y₂O₃) thin film.

In one example, the active layer is IGZO, HIZO, IZO, a-InZnO, a-InZnO, ZnO:F, In₂O₃:Sn, In₂O₃:Mo, Cd₂SnO₄, ZnO:Al, TiO₂:Nb or Cd-Sn-O.

In one example, the etch stop layer is one of, or a composite structure of at least two of a silicon oxide thin film, a silicon nitride thin film and a silicon oxynitride thin film.

In one example, the metal oxide insulating layer has a thickness of 50-2000 Å.

Another aspect of the embodiment of the invention provides a display device comprising the array substrate as mentioned above.

Still another aspect of the embodiments of the invention provides a manufacturing method of an array substrate, comprising: Step 1, depositing a gate metal film on the substrate, and forming a pattern of a gate electrode through one patterning process; Step 2, continuously forming thin films comprising a gate insulating layer, a metal oxide insulating layer and a metal oxide semiconductor layer on the substrate after step 1, and forming a pattern of the metal oxide insulating layer and a pattern of the metal oxide semiconductor layer through a pattering process.

In one example, the step 2 comprises continuously forming on the substrate after the step 1 thin films comprising the gate insulating layer, the metal oxide insulating layer, the metal oxide semiconductor layer and an etch stop layer, and forming the pattern of the metal oxide insulating layer, the pattern of the metal oxide semiconductor layer, an pattern of the etch stop layer pattern and a contact area pattern of a source/drain electrode and the pattern of the metal oxide semiconductor layer through one half-tone or grey tone mask plate with a plurality of etching processes.

In one example, the method further comprising: Step 3, forming a source/drain metal film on the substrate after the step 2, and forming a pattern comprising a source electrode, a drain electrode and a date line through one patterning process; Step 4, forming a passivation layer on the substrate after the step 3, and forming a source electrode contact through hole through one patterning process; and Step 5, depositing a transparent conductive layer on the substrate after the step 4, and forming a transparent conductive pixel electrode through one patterning process.

In one example the step 2 comprises: Step 211, continuously depositing the gate insulating layer by a PECVD method; Step 212, continuously and sequentially depositing the metal oxide insulating layer and the metal oxide semiconductor layer on the gate insulating layer by a sputtering or thermal evaporation method; Step 213, depositing the etch stop layer by the PECVD method; Step 214, after exposure and development via the one half-tone or gray tone mask plate, forming a photoresist-completely-retained area, a photoresist-completely-removed area and a photoresist-partially-removed area; the photoresist-completely-retained area corresponding to a semiconductor protection portion, the photoresist-partially-removed area corresponding to the contact portion of the source/drain electrodes and the semiconductor layer; and removing the etch stop layer and the semiconductor layer in the photoresist-partially-removed area by an etching process; Step 215, conducting an ashing process of a photoresist to remove the photoresist in the photoresist-partially-removed area; and Step 216, conducting an etching process, removing the etch stop layer in the photoresist-partially-removed area to form the contact portion of the source/drain electrodes and the semiconductor layer.

In one example, the metal oxide insulating layer has an area larger than or equal to that of the metal oxide semiconductor layer.

In one example, the metal oxide insulating layer is an aluminum oxide (Al₂O₃) thin film, a tantalum pentoxide (Ta₂O₅) thin film or a yttrium oxide (Y₂O₃) thin film.

In one example, the metal oxide insulating layer has a thickness of 50-2000 Å.

### BRIEF DESCRIPTION OF THE DRAWINGS

In order to clearly illustrate the technical solutions of the embodiments of the invention, the drawings of the embodiments will be briefly described in the following; it is obvious that the described drawings are only related to some embodiments of the invention and thus are not limitative of the invention.
Fig. 1 is a first schematic diagram of an array substrate in the embodiments of the present invention;
Fig. 2 is a second schematic diagram of the array substrate in the embodiments of the present invention;
Fig. 3 is a third schematic diagram of the array substrate in the embodiments of the present invention;
Fig. 4 is a fourth schematic diagram of the array substrate in the embodiments of the present invention;
Fig. 5 is a fifth schematic diagram of the array substrate in the embodiments of the present invention;
Fig. 6 is a sixth schematic diagram of the array substrate in the embodiments of the present invention;
Fig. 7 is a seventh schematic diagram of the array substrate in the embodiments of the present invention;
Fig. 8 is an eighth schematic diagram of the array substrate in the embodiments of the present invention; and
Fig. 9 is a schematic diagram of the structure of the array substrate in the embodiments of the present invention.

### DETAILED DESCRIPTION

In order to make objects, technical details and advantages of the embodiments of the invention apparent, the technical solutions of the embodiment will be described in a clearly and fully understandable way in connection with the drawings related to the embodiments of the invention. It is obvious that the described embodiments are just a part but not all of the embodiments of the invention. Based on the described embodiments herein, those skilled in the art can obtain other embodiment(s), without any inventive work, which should be within the scope of the invention.

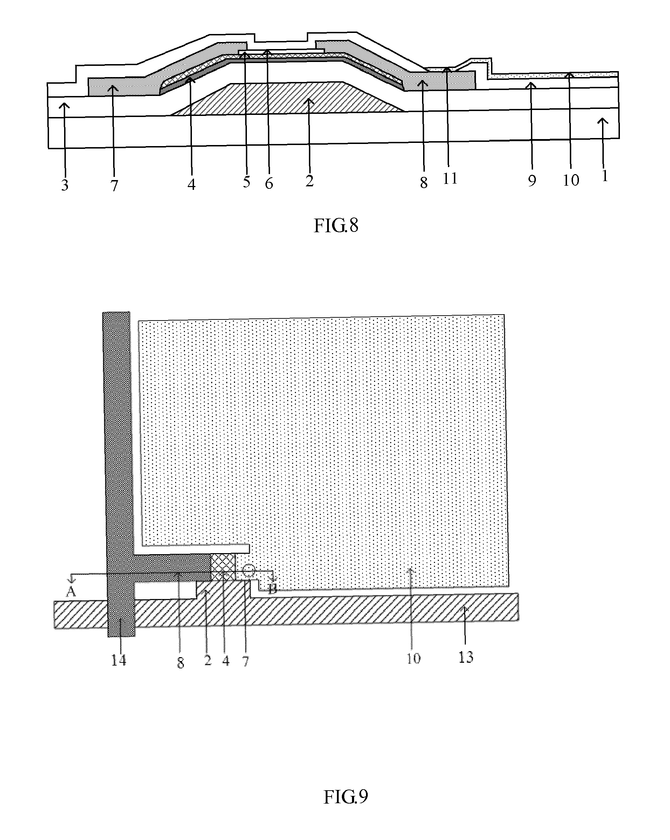

The embodiments of the present invention provide an array substrate, as illustrated in Fig. 9, it comprises a substrate 1; a gate electrode 2, a gate insulating layer 3, an active layer 5, an etch stop layer 6, source/drain electrode layers 7 and 8, a passivation layer 9 and a pixel electrode 10 located on the substrate 1. The active layer 5 is a metal oxide semiconductor, a metal oxide insulating layer 4 is provided between the gate insulating layer 3 and the active layer 5, the gate insulating layer 3 is close to the gate electrode 2, and the metal oxide insulating layer 4 is close to the active layer 5.

For example, the gate insulating layer 3 is located between the gate electrode 2 and the metal oxide insulating layer 4, and the metal oxide insulating layer 4 is located between the gate insulating layer 3 and the active layer 5.

For example, the metal oxide insulating layer 4 contacts the active layer 5.

The active layer 5 is made of a metal oxide semiconductor material, for example, IGZO, HIZO, IZO, a-InZnO, a-InZnO, ZnO:F, In₂O₃:Sn, In₂O₃:Mo, Cd₂SnO₄, ZnO:Al, TiO₂:Nb or Cd-Sn-O. The etch stop layer is any one of, or the composite structure of at least two of a silicon oxide thin film, a silicon nitride thin film and a silicon oxynitride thin film.

The gate insulating layer 3 of the present embodiment is any one of, or a composite structure of a silicon oxide thin film, a silicon nitride thin film and a silicon oxynitride thin film, and it can effectively impede the diffusion of Cu ions. The metal oxide insulating layer 4 is an aluminum oxide (Al₂O₃) thin film, a tantalum pentoxide (Ta₂O₅) thin film or a yttrium oxide (Y₂O₃) thin film. For example, the metal oxide insulating layer has a thickness of 50-2000 Å. The metal oxide insulating layer 4 can effectively prevent H ions in the gate insulating layer 3 from diffusing to the channel of the TFT, and meanwhile further prevent Cu ions passing through the gate insulating layer from diffusing to the active layer 5, thus improve the performance of the resistance Cu wire. In addition, the metal oxide insulating layer 4 is disposed close to the oxide semiconductor active layer 5, and based on the performances of their materials, the contact of the two can form a good stable interface and improve the stability of the TFT at the utmost.

In the embodiments of the present invention, besides the silicon oxide thin film, the silicon nitride thin film and the silicon oxynitride thin film, the gate insulating layer 3 can also use thin films formed by other inorganic insulating materials having the same or similar material characteristics with the above substances. Besides the Al₂O₃ thin film, Ta₂O₅ thin film and Y₂O₃ thin film, the metal oxide insulating layer 4 can also use thin films formed by other inorganic insulating materials having the same or similar material characteristics with the above substances.

In order to protect the active layer satisfactorily and prevent damage to the active layer from the external environment, the surface area of the metal oxide insulating layer 4 is disposed larger than or equivalent to the surface area of the active layer 5 so as to ensure that the metal oxide insulating layer 4 can shield the active layer, and protect the oxide semiconductor active layer 5 at the utmost.

When the metal oxide insulating layer 4 is 50-2000 Å, the fabrication of the metal oxide insulating layer can be ensured in a relative short time, i.e., ensuring the production efficiency, while effectively preventing the TFT channel from being affected by the hydrogen-containing group and preventing Cu ions from diffusing to the oxide semiconductor layer. If the metal oxide insulating layer 4 is too thin, it can not serve the function of preventing the oxide semiconductor from being affected by the hydrogen-containing group or preventing Cu ions from diffusing to the oxide semiconductor layer; if the metal oxide insulating layer 4 is too thick, it needs a longer tact time, thus lowers the production efficiency.

The manufacturing method of the array substrate of the embodiment of the present invention comprises, for example, the following steps:

Step 1, depositing a gate metal film on the substrate, and forming a pattern of a gate electrode through one patterning process.

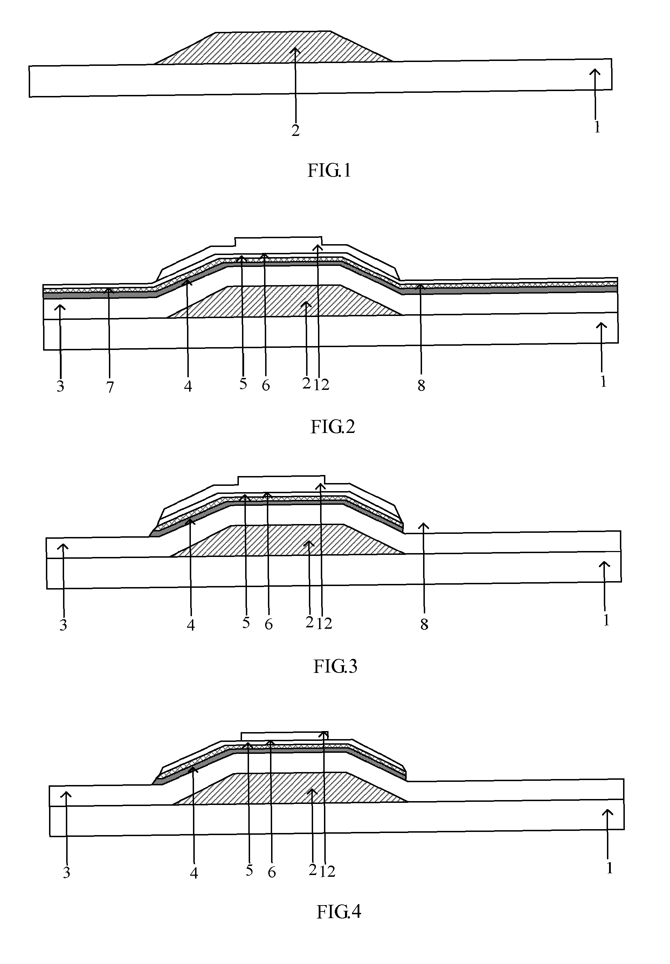

For example, the gate metal film with thicknesses of about 2000-10000 Å is deposited on the substrate 1 using a sputtering or thermal evaporation method. The gate metal film can be selected from a low-resistance Cu metal, wherein the Cu metal is a single layered Cu, or Cu alloy, and can be a multi-layered structure, and a gate metal layer composed of a plurality of layers of metals can also satisfy the needs. The gate electrode 2 is formed by a patterning process with one single tone mask plate, as illustrated in Fig. 1.

Step 2, continuously forming thin films comprising a gate insulating layer, a metal oxide insulating layer and a metal oxide semiconductor layer on the substrate after the step 1, and forming a pattern comprising a metal oxide insulating layer and a pattern of the metal oxide semiconductor layer through a pattering process.

The step 2, for example, is to continuously form the thin films comprising the gate insulating layer, the metal oxide insulating layer, and the metal oxide semiconductor layer, and an etch stop layer on the substrate in after the step 1, and to form a pattern of the metal oxide insulating layer, a pattern of the metal oxide semiconductor layer, a pattern of the etch stop layer, and a contact area pattern of the source/drain electrodes and the metal oxide semiconductor layer pattern through a plurality of etching processes and via one half-tone or grey tone mask plate. The area of the metal oxide insulating layer is larger than or equivalent to the area of the metal oxide semiconductor layer.

For example, step 2 can comprises the following steps:

step 211: continuously depositing the gate insulating layer by a PECVD method;

on the substrate after the step 1, the gate insulating layer 3 with a thickness of 2000-8000 Å is continuously deposited by the PECVD method, wherein the gate insulating layer 3 can select the nitrides and the corresponding reaction gas uses SiH₄, NH₃, N₂ or SiH₂Cl₂, NH₃, N₂;

step 212: continuously and sequentially depositing the metal oxide insulating layer and the metal oxide semiconductor layer on the gate insulating layer by a sputtering or thermal evaporation method;

the metal oxide insulating layer 4 is a metal oxide insulating layer such as Al₂O₃ thin film, Ta₂O₅ thin film or Y₂O₃. The thickness of the metal oxide insulating layer is, for example, 50-2000 Å. The metal oxide semiconductor layer 5 is made of, for example, amorphous IGZO, HIZO, IZO, a-InZnO, a-InZnO, ZnO:F, In₂O₃:Sn, In₂O₃:Mo, Cd₂SnO₄, ZnO:Al, TiO₂:Nb, Cd-Sn-O or other metal oxides. The thickness of the metal oxide semiconductor layer is, for example, 100-2000 Å,

step 213, depositing the etch stop layer by a PECVD method;

The etch stop layer 6 with a thickness of 500-4000 Å is deposited by the PECVD method. The etch stop layer is oxide, nitride or oxynitride. The oxide of the silicon corresponds to the reaction gas of SiH₄, N₂O; the nitride or oxynitride corresponds to the reaction gas of SiH₄, NH₃, N₂ or SiH₂Cl₂, NH₃, N₂; and the stop layer can also use Al₂O₃, or a double-layered stop structure.

Step 214: after exposure and development by one half-tone or gray tone mask plate, a photoresist-completely-retained area, a photoresist-completely-removed area and a photoresist-partially-removed area are formed; the photoresist-completely-retained area corresponds to a semiconductor protection portion (i.e., the portion to form the etch stop layer pattern), the photoresist-partially-removed area corresponds to the contact portion of the source/drain electrodes and the semiconductor layer; and the etch stop layer and the semiconductor layer in the photoresist-completely-removed area are removed by etching process, as illustrated in Figs. 2-3.

Step 215: conducting an ashing process on the photoresist to remove the photoresist in the photoresist-partially-removed area, as illustrated in Fig. 4.

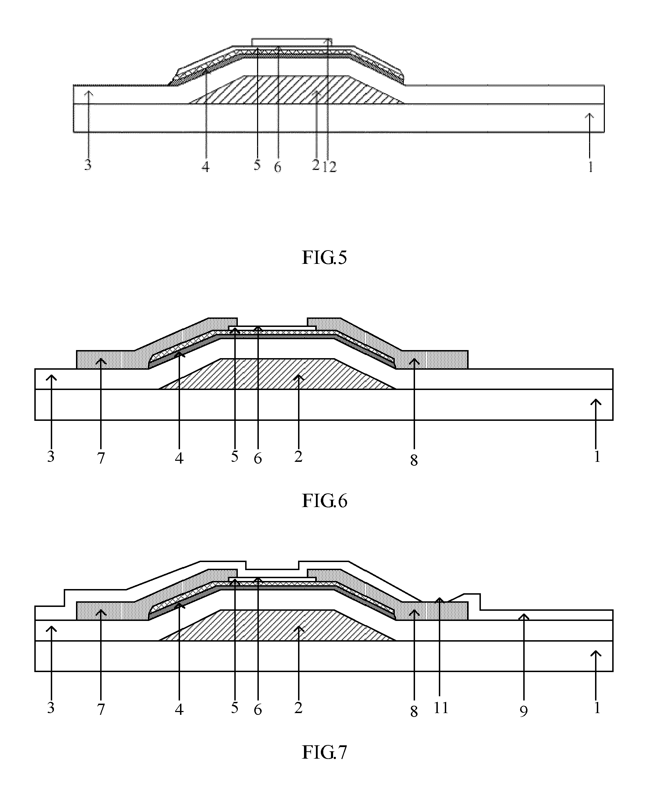

Step 216: conducting an etching process, removing the etch stop layer in the photoresist-partially-removed area to form the contact portion of the source/drain electrodes and the semiconductor layer, as illustrated in Fig. 5.

Step 3, depositing a source/drain metal film on the substrate after the step 2, and forming a source electrode, a drain electrode and a date line via one patterning process.

For example, the source/drain metal film with a thicknesses of 2000-10000 Å is deposited on the substrate after the step 2 using the sputtering or thermal evaporation method. The source/drain metal film can be selected from metals or alloys of Cr, W, Cu, Ti, Ta, Mo and etc., and the gate metal layer composed of a plurality of layers of metals can also satisfy the needs. The source electrode 8, the drain electrode 7 and the data line 14 are formed by one patterning process with one single tone mask plate, as illustrated in Fig. 6.

Step 4, continuously depositing a passivation layer on the substrate in after the step 3, and forming a drain electrode contact through hole by one patterning process;

For example, a passivation layer 9 with a thickness of 1000-3000 Å is continuously deposited on the substrate after the step 3 by a PECVD method. The passivation layer can be selected from oxide, nitride or oxynitride, and the corresponding reaction gas can be SiH₄, NH₃, N₂ or SiH₂Cl₂, NH₃, N₂; the drain electrode contact through hole 11 is formed by one patterning process with one single tone mask plate, as illustrated in Fig. 7.

Step 5, depositing a transparent conductive layer 10 on the substrate after the step 4, and forming a transparent conductive pixel electrode by one patterning process.

The transparent conductive layer 10 with a thickness of about 300-1500 Å is continuously deposited in the substrate after the step 4 by a sputtering or thermal evaporation method. The transparent conductive layer is ITO (Indium Tin Oxide) or IZO (Indium Zinc Oxide); and the transparent conductive pixel electrode is formed by one patterning process with one single tone mask plate, as illustrated in Fig. 8.

The patterning process in the embodiments of the present invention comprises processes such as photoresist coating, masking, exposing, developing, etching, photoresist removing, and the photoresist takes a positive photoresist as an example, but it is not a limitation to the present invention.

The manufacturing method of the array substrate provided by the embodiment of the present invention adopts a five-patterning process during making the metal oxide TFT, and forms the etch stop layer pattern and the semiconductor layer pattern at the same time by using one half-tone or grey tone mask plate. Compared with the six-patterning process, the manufacturing method reduces one patterning process, simplifies the production process, improves the production efficiency, and thus is of high use value.

In addition, the embodiments of the present invention further provide a display device, and the display device comprises the above array substrate. The display device can also be any product or component having a display function, such as liquid crystal panel, electronic paper, OLED panel, liquid crystal TV, liquid crystal display, digital picture frame, mobile phone, and flat panel computer.

The foregoing is merely exemplary embodiments of the invention, but is not used to limit the protection scope of the invention. The protection scope of the invention shall be defined by the attached claims.

## Claims

1. An array substrate, comprising:
a substrate; a gate electrode, a gate insulating layer, an active layer, an etch stop layer, a source/drain electrode layer, a passivation layer and a pixel electrode layer on the substrate; wherein,
the active layer is a metal oxide semiconductor,
a metal oxide insulating layer is provided between the gate insulating layer and the active layer,
the gate insulating layer is located between the gate electrode and the metal oxide insulating layer, and the metal oxide insulating layer is located between the gate insulating layer and the active layer.

2. The array substrate according to Claim 1, wherein, the metal oxide insulating layer has an area larger than or equal to that of the active layer.

3. The array substrate according to Claim 1 or 2, wherein, the metal oxide insulating layer contacts the active layer.

4. The array substrate according to any of Claims 1 to 3, wherein, the gate electrode is copper or copper alloy.

5. The array substrate according to any of Claims 1 to 4, wherein, the metal oxide insulating layer is an aluminum oxide (Al₂O₃) thin film, a tantalum pentoxide (Ta₂O₅) thin film or a yttrium oxide (Y₂O₃) thin film.

6. The array substrate according to any of Claims 1 to 5, wherein, the etch stop layer is one of, or a composite structure of at least two of a silicon oxide thin film, a silicon nitride thin film and a silicon oxynitride thin film.

7. The array substrate according to any of Claims 1 to 6, wherein, the metal oxide insulating layer has a thickness of 50-2000 Å.

8. A display device comprising the array substrate according to any of Claims 1 to 7.

9. A manufacturing method of an array substrate, comprising:
Step 1, depositing a gate metal film on the substrate, and forming a pattern of a gate electrode through one patterning process;
Step 2, continuously forming thin films comprising a gate insulating layer, a metal oxide insulating layer and a metal oxide semiconductor layer on the substrate after step 1, and forming a pattern of the metal oxide insulating layer and a pattern of the metal oxide semiconductor layer through a pattering process.

10. The method according to Claim 9, wherein, the step 2 comprises continuously forming on the substrate after the step 1 thin films comprising the gate insulating layer, the metal oxide insulating layer, the metal oxide semiconductor layer and an etch stop layer, and forming the pattern of the metal oxide insulating layer, the pattern of the metal oxide semiconductor layer, an pattern of the etch stop layer pattern and a contact area pattern of a source/drain electrode and the pattern of the metal oxide semiconductor layer through one half-tone or grey tone mask plate with a plurality of etching processes.

11. The method according to Claim 9 or 10, further comprising:
Step 3, forming a source/drain metal film on the substrate after the step 2, and forming a pattern comprising a source electrode, a drain electrode and a date line through one patterning process;
Step 4, forming a passivation layer on the substrate after the step 3, and forming a source electrode contact through hole through one patterning process; and
Step 5, depositing a transparent conductive layer on the substrate after the step 4, and forming a transparent conductive pixel electrode through one patterning process.

12. The method according to any of Claims 9 to 11, wherein,
the step 2 comprises:
Step 211, continuously depositing the gate insulating layer by a PECVD method;
Step 212, continuously and sequentially depositing the metal oxide insulating layer and the metal oxide semiconductor layer on the gate insulating layer by a sputtering or thermal evaporation method;
Step 213, depositing the etch stop layer by the PECVD method;
Step 214, after exposure and development via the one half-tone or gray tone mask plate, forming a photoresist-completely-retained area, a photoresist-completely-removed area and a photoresist-partially-removed area; the photoresist-completely-retained area corresponding to a semiconductor protection portion, the photoresist-partially-removed area corresponding to the contact portion of the source/drain electrodes and the semiconductor layer; and removing the etch stop layer and the semiconductor layer in the photoresist-partially-removed area by an etching process;
Step 215, conducting an ashing process of a photoresist to remove the photoresist in the photoresist-partially-removed area; and
Step 216, conducting an etching process, removing the etch stop layer in the photoresist-partially-removed area to form the contact portion of the source/drain electrodes and the semiconductor layer.

13. The method according to any of Claims 9 to 12, wherein, the metal oxide insulating layer has an area larger than or equal to that of the metal oxide semiconductor layer.

14. The method according to any of Claims 9 to 13, wherein, the metal oxide insulating layer is an aluminum oxide (Al₂O₃) thin film, a tantalum pentoxide (Ta₂O₅) thin film or a yttrium oxide (Y₂O₃) thin film.

15. The method according to any of Claims 9 to 14, wherein, the metal oxide insulating layer has a thickness of 50-2000 Å.
